(19)

**Europäisches Patentamt**
**European Patent Office**
**Office européen des brevets**

(11) **EP 2 538 553 A1**

(12) **EUROPEAN PATENT APPLICATION**

(43) Date of publication:
**26.12.2012 Bulletin 2012/52**

(51) Int Cl.:
*H03F 1/32* (2006.01) *H04L 25/03* (2006.01)
*H04L 27/36* (2006.01)

(21) Application number: **11305781.4**

(22) Date of filing: **21.06.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventors:
• **Jüschke, Patrick**
**75428 Illingen (DE)**

• **Wiegner, Dirk**
**71409 Schwaikheim (DE)**
• **Brendel, Johannes**
**95119 Naila/Marxgrün (DE)**

(74) Representative: **2SPL Patentanwälte**
**Postfach 15 17 23**
**80050 München (DE)**

Remarks:
Amended claims in accordance with Rule 137(2) EPC.

(54) **Apparatus and method for mitigating impairments of a transmit signal**

(57) Embodiments relate to a concept for mitigating impairments due to transmit noise. Provided is apparatus (10) for mitigating transmitter impairments of a transmit signal, the apparatus comprising an input (11a; 11b) for an in-phase and a quadrature component (12a; 12b) of a digital baseband transmit signal (12), a pre-distortion neural network processor (13) for pre-distorting the input digital baseband transmit signal (12; 12a; 12b) to obtain a pre-distorted digital baseband signal (16; 16a; 16b), wherein the pre-distortion neural network processor (13) is adaptable to a transmitter transfer function of at least one analog transmitter device (14) arranged downstream to the pre-distortion neural network processor (13) such that a transfer function of the pre-distortion neural network processor (13) approximates an inverse of said transmitter transfer function, and an output (15a; 15b) for an in-phase and a quadrature component (16a; 16b) of the pre-distorted digital baseband signal (16), which may be coupled to an input of the at least one analog transmitter device (14) arranged downstream to the pre-distortion neural network processor (13)

Fig. 1

**EP 2 538 553 A1**

**Description**

Embodiments of the present invention generally relate to wireless communications and, more specifically, to a concept for mitigating impairments of a transmit signal due to transmitter imperfections.

Background

Wireless networks are steadily growing and an increasing number of systems for mobile communications are deployed. For example, multiple generations of cellular systems have been developed and introduced to the mass markets. While 2nd generation cellular communication systems, like e.g. GSM (Global System for Mobile Communications), have been mainly introduced to meet traditional demands for circuit switched voice communications with comparatively low data rates, 3rd and 4th generation mobile communication systems, like e.g. UMTS (Universal Mobile Telecommunication System) and LTE (Long-Term Evolution), are getting increasingly complex to meet the ever increasing demands for higher and higher data rates needed for packet based mobile communications. A constantly rising capacity of the mobile communication systems as well as a general demand to reduce power consumption to get mobile communication systems greener are a big challenge, in particular with respect to transceivers and their Radio Frequency (RF) parts. Furthermore, today's mobile radio access networks, which are mainly determined by a radio frontend of the base stations have to deal with different standards and signal requirements spread over a wide frequency range.

The higher-order modulated signals of current mobile communications standards like LTE or Wireless Local Area Networks (WLANs) pose high demands on radio systems regarding signal requirements while causing a higher Peak-to-Average Power Ratio (PAPR) due to amplitude-modulated signal components within the transmit signal. This however yields less efficiency in power amplifier modules, which is contradicting the envisaged green aspects. To get a better trade-off between rising capacity causing higher PAPR and green aspects requiring highly efficient power amplifiers it is necessary to operate a transmitter line-up in a most efficient state.

Advanced receiver signal processing algorithms are, on the one hand, very powerful in that they potentially allow performances closer and closer to physical limits. However, such signal processing algorithms are designed under certain idealized assumptions that are not always fulfilled in real-world communication systems. Instead, physical implementations of RF transmitters suffer from a number of impairments that degrade the quality of the received signal beyond the impact of fading or thermal-noise at the receiver. Analog components in the transmit chain, which will also be referred to as transmitter devices in the sequel, typically cause various impairments because of their imperfect behavior. Most prominent non-idealities are carrier-frequency and sampling-rate offset, phase-noise, IQ-imbalance (I = In-phase signal component, Q = Quadrature signal component), and Power Amplifier (PA) nonlinearities. Especially the mixer after the digital to analog converter, which is responsible for mixing the baseband signal with the carrier signal, may cause so called IQ imbalance imperfections. Beside the mixer, the PA is another source of impairments. The non-linear behavior of the PA characteristic close to the saturation point adds impairments to the transmit signal, too. The non-linearity of the PA mainly results in sideband emission and affects spectrum emission requirements. In the sequel, the combination of all those impairments at a transmitter will also be referred to as transmit noise (TX noise). The transmit noise may be interpreted as a deviation of a physical, i.e. real-world RF transmit signal from an ideal transmit signal constellation due to the aforementioned transmitter non-idealities.

The impact of TX noise may be at least partially compensated by classical algorithms. Separate/different linearization and compensation algorithms, that are particularly designed to solve these problems, may compensate at least some of the aforementioned TX impairments more or less accurately (depending on the algorithm), e.g. using signal processing in the digital part of the transceiver chain. For example, at the transmitter TX noise may be at least partially compensated by means of calibration or pre-distortion, or at the receiver using sophisticated compensation algorithms. However, such classical algorithms are quite fixed and, hence, not really flexible and a bottle-neck, in particular for increasingly complex mobile communication system architectures. For example, in case of fragmented spectrum applications due to the realities of decreasing electromagnetic spectrum availability, current compensation algorithms do not have a desired flexibility to handle signals with fragmented carriers.

Therefore, it is desirable to have a more flexible radio transmitter that can support as many standards and signals as possible. Beside the interest on increased flexibility from the outside view, a high flexibility within the transceiver system has the advantage, that different parts of the system can be exchanged and adapted easily, like the flexibility to use the digital part with different analog components without reconfiguration. This is not only true for macro-cell base stations but also for small-cell base stations.

Hence, it is desirable to provide an improved concept for handling impairments of a transmit signal due to imperfections of a transmitter.

Summary

Embodiments of the present invention may be based on the finding that (artificial) neural networks (NNs) have high flexibility and advantages regarding solving (non-) deterministic and complex problems without the necessity to describe them algorithmically. Another finding is that neural networks can handle multiple problems simultaneously. Therefore no complex interaction between different components or algorithms, suited for different types of problems, is needed and problems do not have to be separated, what relaxes the solution of a certain problem.

According to embodiments, a neural network may applied to the mitigation of transmitter impairments of a transmit signal, such impairments being in particular the IQ imbalance due to an IQ up-conversion mixer in the transmit path of a transceiver, as well as nonlinearities due to a power amplifier (PA) in said transmit path.

For that purpose embodiments provide an apparatus for mitigating transmitter impairments of a transmit signal, the apparatus comprising an input for an in-phase and a quadrature component of a digital baseband transmit signal, wherein the in-phase and the quadrature components both are real-valued signals, respectively. The apparatus further comprises a pre-distortion neural network processor for pre-distorting the input digital baseband transmit signal to obtain a pre-distorted digital baseband signal, wherein the pre-distortion neural network processor is adapted to a transmitter transfer function of at least one analog transmitter device arranged downstream to the pre-distortion neural network processor such that a transfer function of the pre-distortion neural network processor approximates an inverse of said transmitter transfer function. The apparatus also comprises an output for an in-phase and a quadrature component of the pre-distorted digital baseband signal, which may be coupled to an input of the at least one analog transmitter device arranged downstream to the neural network.

The at least one analog transmitter device may comprise an IQ up-conversion mixer comprising an In-phase (I) channel up-conversion mixer and a Quadrature (Q) channel up-conversion mixer. Such an IQ up-conversion mixer up-converts IQ baseband signals transmitted from an IQ Digital-to-Analog Converter (DAC) to Radio Frequency (RF) IQ signals. In order to achieve this, the IQ up-conversion mixer may combine or multiply the analog baseband I channel signal being outputted from the IQ DAC with an appropriate in-phase Local Oscillator (LO) signal, e.g. $\cos(2\pi f_c t)$, with $f_c$ being the RF carrier frequency. In addition, the IQ up-conversion mixer may multiply the analog baseband Q channel signal being outputted from the IQ DAC to an appropriate quadrature LO signal, e.g. $\sin(2\pi f_c t)$. In an ideal IQ modulator, the phase difference between the in-phase and quadrature LO signal used for modulating the I-branch and Q-branch is 90°, resulting in using $\cos(2\pi f_c t)$ and $\sin(2\pi f_c t)$ for sending the I and Q components. However, real-world IQ modulators will introduce at least slight amplitude and/or phase imbalances between the I- and Q-components. When there is a phase imbalance, the phase difference between I and Q might not exactly be 90°. We may consider that $\cos(2\pi f_c t)$ is used for sending the I-component and $\sin(2\pi f_c t+\theta)$ for sending the Q-component. When there is amplitude imbalance, there is a small variation in the amplitude of the I-branch and Q-branch of the modulator. This can be modeled as using $\cos(2\pi f_c t)$ for sending the I-component and using $(1+\alpha)\sin(2\pi f_c t)$ for sending Q-component, where $\alpha$ denotes constant lying between 0 and 1, for example.

Hence, in order to mitigate the IQ imbalance, which may lead to undesired RF signal images, embodiments of the apparatus' pre-distortion neural network processor may be adapted to compensate a non-ideal transmitter transfer function of the at least one analog transmitter device causing an IQ imbalance between the in-phase and the quadrature component of the transmit signal.

For this purpose the pre-distortion neural network processor may comprise a multi-layer feed forward neural network (MLNN), also referred to as multi-layer perceptron (MLP), having an input layer for the in-phase and the quadrature components of the digital baseband transmit signal and, optionally, delayed versions thereof, one or more hidden layers, and an output layer for the in-phase and the quadrature component of the pre-distorted digital baseband signal. Thereby a hidden layer is an intermediate layer between the input and the output layer, the intermediate layer comprising basic computational units known as hidden neurons. A function of hidden neurons is to intervene between the input layer and the output layer in some useful manner. By adding one or more hidden layers, the neural network is enabled to extract higher-order statistics. One might say that the neural network acquires a global perspective despite its local connectivity due to the extra set of synaptic connections. The source nodes in the input layer of the network supply respective elements of the activation pattern (input vector), which constitute the input signals applied to the neurons (computation nodes) in the second layer, i.e. the first hidden layer. The output signals of the second layer are used as inputs to the third layer, and so on for the rest of the network. Typically the neurons in each layer of the network have as their inputs the output signals of the preceding layer only. The set of output signals of the neurons in the output (final) layer of the network constitutes the overall response of the network to the activation pattern supplied by the source notes in the input (first) layer.

A neuron is an information-processing unit that is fundamental to the operation of the neural network. This the basic elements of the neuronal model are a set of synapses or collecting links, each of which is characterized by a weight was drawings of its own. Specifically, a signal $x_j$ at an input of synapse j connected to neuron k is multiplied by the synaptic weight $w_{kj}$. An adder sums up the input signals, weighted by the respective synaptic weights. An activation function limits the amplitude of the output of the neuron. Hence, an artificial neuron k is composed of a linear combiner followed by the activation or transfer function. A neuron receives inputs $x = [x_1, x_2, \ldots, x_N]^T$ from other processors of the neural network. The linear combiner output $f(\mathbf{x})$ is the weighted sum of the inputs $x = [x_1, x_2, \ldots, x_N]^T$ plus a bias term $b_k$. The activation function then yields the $k$-th neuron's output y according to

$$y = f(\mathbf{x}) = f\left( \sum_{j=1}^{N} w_{kj} x_j + b_k \right). \tag{1}$$

According to some embodiments the input layer may also comprise a plurality (e.g. three) delay elements connected in series to from a delay line, for delaying input samples of the in-phase and/or the quadrature component of the digital baseband transmit signal, respectively. This is particularly advantageous for mitigating IQ imbalance impairments due to analog transmitter devices, as e.g. IQ up-conversion mixers, with memory effects.

Regarding the mitigation of IQ imbalance, which is a dominant linear problem, the neurons of the pre-distortion feed-forward neural network may comprise an at least piecewise linear transfer or activation function $f(\cdot)$, like e.g. a saturating linear function. Of course the activation function may also be purely linear.

In order to fit the feed-forward pre-distortion neural network to a specific downstream hardware component, the apparatus may further comprise a training processor for training weight and/or bias parameters $(w_{kj}, b_k)$ of neurons of the pre-distortion neural network processor. The training processor may comprise a so-called post distortion neural network processor having the same network structure as the pre-distortion neural network processor. The training processor may be adapted to train the weight and/or bias parameters of the post distortion neural network processor using the Levenberg-Marquardt training algorithm and to transfer the trained weight and/or bias parameters of the post distortion neural network processor to the pre-distortion neural network processor upstream to the analog transmitter hardware.

The post-distortion neural network processor may be used to identify the inverse transfer function of the non-ideal transmitter device's transfer function using supervised learning. A pair of the transmitter device's input - output signals is presented to the post distortion neural network processor during each training iteration. Gradient-based training algorithms, like back-propagation, may be used. However, they are not very efficient due to the fact that the gradient vanishes at the solution. Hessian-based algorithms allow the neural network to learn more subtle features of a complicated mapping. The training process converges quickly as the solution is approached, because the Hessian does not vanish at the solution. To benefit from the advantages of Hessian based training, embodiments focus on the well-known Levenberg-Marquardt algorithm. The Levenberg-Marquardt algorithm is basically a Hessian-based algorithm for nonlinear least squares optimization.

During training, original, i.e. non pre-distorted, I- and Q-samples or a (delayed) signal derived therefrom may be used as target output data for the post distortion neural network processor, while output samples of the non-ideal analog transmitter device or a signal derived therefrom may be used as input data for the post distortion neural network processor. As the training of the post distortion neural network processor converges, its response or transfer function will approximate the inverse transfer function of the non-ideal transmitter device's transfer function. In other words, the output layer of the post distortion neural network processor may be coupled to the in-phase and the quadrature component of the (undistorted) digital baseband transmit signal, while its input layer may be coupled to the output of the non-ideal analog transmitter device.

According to further embodiments the pre-distortion neural network processor and, hence, the post distortion neural network processor as well, may be structurally adapted to additionally or alternatively invert a nonlinear transmitter transfer function of at least one nonlinear analog power amplifier device, as e.g. a Traveling Wave Amplifier (TWA) or a Travelling Wave Tube Amplifier (TWTA) or a Doherty amplifier, which may be comprised by the analog transmitter device.

For this purpose the pre-distortion neural network processor may comprise an input layer for the in-phase and the quadrature components of the digital baseband transmit signal and possibly delayed versions thereof, preferably two hidden layers, and an output layer for the in-phase and the quadrature component of the pre-distorted digital baseband signal. The post distortion neural network processor consequently has an identical structure with identical computational units or neurons, such that the trained weights $w_{kj}$ and bias values $b_k$ of the individual neurons may simply be transferred from the post distortion neural network processor to the pre-distortion neural network processor after the training has completed.

According to embodiments the neurons of the preferably two hidden layers have nonlinear transfer or activation functions with a hyperbolic tangent characteristic, such as sigmoid transfer or activation functions. Due to this s-shaped activation functions the pre-distortion neural network processor gains the ability to compensate, i.e. linearize, arbitrary nonlinear power amplifiers. In contrast thereto, the neurons of the output layer may have at least piecewise or strictly linear activation functions for compensating TX impairments due to IQ imbalance.

In some embodiments the neurons may operate with input and/or output values between - 1 and 1, for example. In this case an output of a neuron can have a value between -1 and 1. Also, it may be advantageous to scale or norm the input values of the neural network, i.e. the in-phase and quadrature components of the baseband transmit signal, accordingly to the middle of the respective range of absolute values, which is 0.5, for example. Such an input scaling to the middle of the range of output values of the activation functions or neurons may allow a pre-distortion of the in-phase and quadrature components in both directions to a maximum possible extent, i.e. a high dynamic pre-distortion range.

Furthermore, an additional direct path from the input to the output layer, hence bypassing the hidden layer(s), may be foreseen in the network topology of the pre-distortion neural network processor. That is to say, that the pre-distortion neural network processor comprises a network topology such that output signals of the input layer are directly forwarded to the output layer and to one of the hidden layers (preferably the first one). Hence, embodiments of the pre-distortion neural network processor gain the ability to split the linearization problem into a dominant linear part (output layer) and a nonlinear part (hidden layer(s)), which relaxes the requirements for the hidden layer size.

Also, at the input layer of the pre-distortion neural network not only the IQ baseband samples but also their absolute value may be provided to the pre-distortion neural network processor. With this pre-calculated additional information the nonlinear effects, which are in most cases dependent on the power of the signal, may be described with less effort of the pre-distortion neural network processor. Hence, the apparatus may further comprise an input for an absolute value of the digital baseband transmit signal comprising the in-phase and the quadrature component, wherein the pre-distortion neural network processor may be adapted to process the absolute value in addition to the in-phase and the quadrature component of the digital baseband transmit signal. This may lead to a satisfying linearization performance with as few as ten artificial neurons in each hidden layer and two artificial neurons in the output layer.

Again, the proposed pre-distortion neural network may be extended by introducing a time delay line (TDL) at the pre-distortion neural network input layer. With this modification also memory effects in a power amplifier and/or an IQ up-conversion mixer may be compensated. The input layer may hence be coupled to a plurality of delay elements connected in series for delaying samples of the in-phase and/or the quadrature component and/or an absolute value of the input digital baseband transmit signal, respectively.

Some embodiments of the apparatus may also be applied to fragmented spectrum applications, e.g., when using a single transceiver device for transmitting in spectrally separated frequency bands of different mobile communication systems. That is to say, a transmitter may comprise digital and non-ideal analog circuitry for supporting two or more frequency bands in parallel, e.g., using two or more mixers (one per frequency band) and a power amplifier (one per frequency band or a common one). By parallel operation of fragmented frequency bands, the number of parameters to be considered for non-linearity compensation of the transmitter rises, thus leading to increased challenges for optimization considering all the problems.

By using embodiments of the self learning/optimizing neural network, the parameters (addressing I/Q-imbalance and PA non-linearity in parallel for different frequency bands) may commonly be considered and optimized by embodiments of the present invention in a more advanced manner compared to use dedicated, non-self-learning algorithms. Information of the signal quality can e.g. be provided to the neural network by use of a feedback path in time multiplexed manner, e.g. by temporally changing an LO-frequency of a mixer in the feedback path. Hence, the apparatus may be adapted for parallel operation of spectrally fragmented frequency bands, wherein the pre-distortion neural network processor is adapted to pre-distort the input digital baseband transmit signal to obtain a plurality of pre-distorted digital baseband signals, wherein each of the pre-distorted digital baseband signals corresponds to a different one of the fragmented frequency bands. In some embodiments each of the pre-distorted digital baseband signals may correspond to a different one of a plurality of analog transmitter devices, each of the analog transmitter devices corresponding to a different one of the plurality fragmented frequency bands.

Yet further embodiments provide a method for mitigating transmitter impairments of a transmit signal, the method comprising receiving an in-phase and a quadrature component of a digital baseband transmit signal, pre-distorting the in-phase and quadrature component of the digital baseband transmit signal using a pre-distortion neural network to obtain a pre-distorted digital baseband signal, wherein the pre-distortion neural network is adapted to a transmitter transfer function of at least one analog transmitter device arranged downstream to the pre-distortion neural network such that a transfer function of the pre-distortion neural network approximates an inverse of said transmitter transfer function, and outputting an in-phase and a quadrature component of the pre-distorted digital baseband signal, which may be coupled to an input of the at least one analog transmitter device arranged downstream to the pre-distortion neural network.

Some embodiments comprise digital control circuits installed within the apparatus' electrical circuitry. Such a digital control circuit, e.g. a digital signal processor (DSP), needs to be programmed accordingly. Hence, yet further embodiments also provide a computer program having a program code for performing at least a step of embodiments of the aforementioned method, when the computer program is executed on a computer or a digital processor.

Embodiments may practicably enable to get a self-intelligent and self-adapting solution in order to increase flexibility of a whole RF transmitter comprising digital and analog parts. The digital part of the transmitter may become more flexible regarding an analog frontend arranged downstream thereto. Any mixer or PA could be used without analyzing its components to adjust dedicated impairment algorithms. The use of pre-distortion neural networks according to embodiments show very good results for impairment mitigation within the RF transmitter chain.

Brief description of the Figures

Some embodiments of apparatuses and/or methods will be described in the following by way of example only, and with reference to the accompanying figures, in which

Fig. 1        shows a schematic block diagram of an apparatus for mitigating impairments of a transmit signal, according to an embodiment;

Fig. 2        shows a schematic representation of a fully connected feed-forward neural network with one input layer coupled to a delay line, one hidden layer, and one output layer;

Fig. 3        shows a schematic block diagram of a pre-distortion network for mitigating IQ-imbalance impairments, according to an embodiment;

Fig. 4        shows a schematic block diagram of an apparatus for mitigating impairments of a transmit signal comprising both a pre-distortion neural network and a training processor with a post distortion neural network;

Fig. 5a, b   show schematic block diagrams of a first pre-distortion network for mitigating IQ-imbalance and nonlinear PA impairments, according to an embodiment;

Fig. 5c       shows a schematic block diagram of a second pre-distortion network for mitigating IQ-imbalance and non-linear PA impairments, according to an embodiment;

Fig. 6        shows a schematic block diagram of an apparatus for mitigating impairments of a transmit signal in a fragmented spectrum scenario, according to an embodiment; and

Fig. 7        shows a schematic flow chart of steps of a method for mitigating impairments of a transmit signal, according to an embodiment.

Description of Embodiments

Various example embodiments will now be described more fully with reference to the accompanying drawings in which some example embodiments are illustrated. In the drawings, the thicknesses of layers and/or regions may be exaggerated for clarity.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

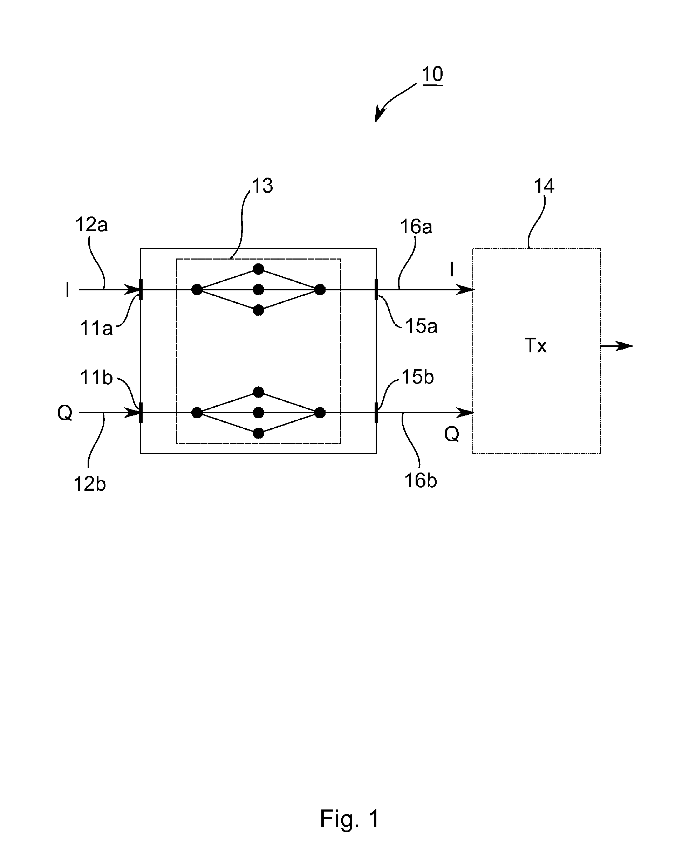

Fig. 1 schematically shows a block diagram of an apparatus 10 for mitigating impairments of a transmit signal due to one or more non-ideal analog transmitter components.

The apparatus 10 comprises an input 11a, 11b for an in-phase component 12a and a quadrature component 12b of a digital baseband transmit signal 12. The input signals 12a, 12b are coupled to a pre-distortion neural network processor 13 for pre-distorting the input digital baseband transmit signal 12 in order to obtain a pre-distorted digital baseband signal 16 with quadrature components 16a, 16b. The pre-distortion neural network processor 13 is thereby adaptable or adapted to a transmitter transfer function of at least one analog transmitter device 14 arranged downstream to the pre-distortion neural network processor 13 such that a transfer function of the pre-distortion neural network processor 13 approximates an inverse of said transmitter transfer function. The apparatus 10 further comprises an output 15a, 15b for outputting an in-phase and a quadrature component 16a, 16b of the pre-distorted digital baseband signal 16, which may be coupled to an input of the at least one analog transmitter device 14 arranged downstream to the pre-distortion neural network processor 13.

In-phase and quadrature components 12a, 12b of the digital baseband transmit signal 12 are separately fed into the pre-distortion neural network processor 13, such that, according to some embodiments, in-phase and quadrature neural network components of the pre-distortion neural network processor 13 may be adapted to compensate for a transmitter transfer function of a non-ideal analog transmitter device 14 which is causing an IQ imbalance with respect to phase and/or amplitude between the in-phase and the quadrature components at its output. In the case of mitigating an IQ imbalance, the at least one analog transmitter device 14 may e.g. comprise an IQ up-conversion mixer, which has been explained above. In this case the pre-distortion neural network processor 13 approximates the inverse transfer function of the IQ up-conversion mixer, such that an overall concatenated transfer function is approximately 1.

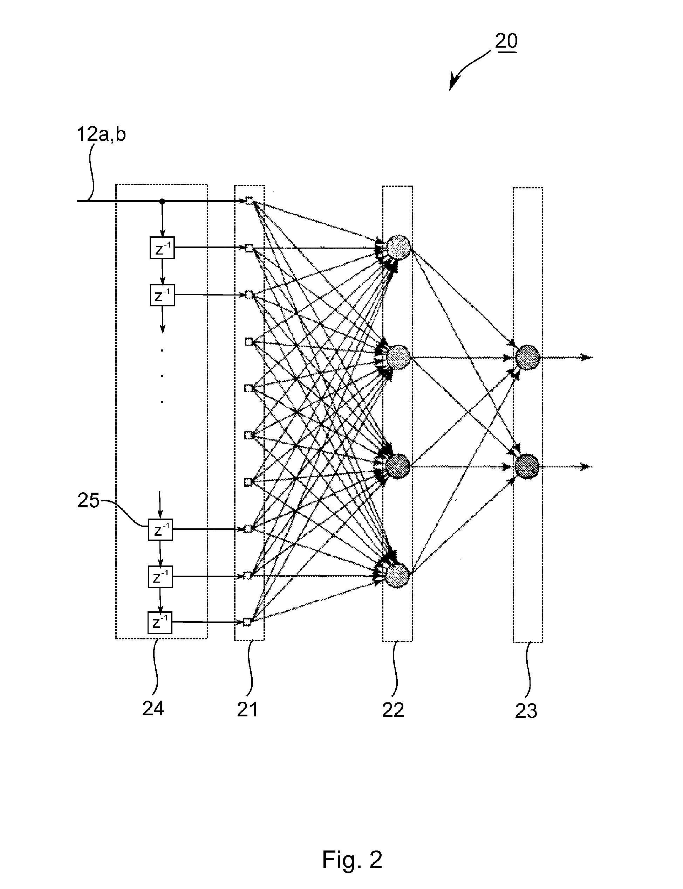

Although not limited thereto, the pre-distortion neural network processor 13 may comprise a feed-forward neural network having a plurality of layers for each of the in-phase and the quadrature component 12a, 12b, respectively. That is to say, the feed-forward neural network may comprise dedicated in-phase and quadrature multilayer neural network components. For each of the real-valued digital baseband signal components 12a, 12b, an input layer, at least one hidden layer, and an output layer of the multilayer feed-forward neural network may be foreseen, as is schematically depicted in Fig. 2.

For the ease of understanding Fig. 2 exemplarily shows the structure of a multilayer feed-forward neural network 20 comprising an input layer 21 of a plurality of source nodes, a hidden layer 22 of a plurality of hidden neurons or units, and an output layer 23 of one or more output neurons. For example, the multilayer feed-forward neural network 20 may be coupled to a real valued in-phase or quadrature component 12a, 12b via a time delay line (TDL) structure, as indicated in Fig. 2 by the dashed box 24. The pre-distortion neural network processor 13 may hence comprise an input layer 21 for each of the in-phase and the quadrature components 12a, 12b of the digital baseband transmit signal 12 and preferably delayed versions thereof, one or more hidden layers 22 for each of the I and Q components 12a, 12b, and an output layer 23 for each of the I and Q components of the pre-distorted digital baseband signal 16. In a particular embodiment the pre-distortion neural network processor 13 may comprise two hidden layers 22 as will be detailed further below.

In the exemplary case of Fig. 2 a first (upper) input node of the multilayer feed-forward neural network 20 forwards a current (non-delayed) sample of a quadrature signal component 12a or 12b to all of the neurons of the subsequent hidden layer 22. The other input nodes forward delayed samples of a quadrature signal component 12a or 12b to all of the neurons of the hidden layer 22, respectively. Hence, the input layer 22 of the multilayer feed-forward neural network 20 may be coupled to a plurality of delay elements 25 connected in series for delaying the in-phase and/or the quadrature component 12a, 12b of the digital baseband transmit signal 12, respectively. In a particular embodiment, e.g. three delay elements may be connected in series to form a time delay line coupled to the input nodes of the respective input layer 22 in order to account for memory effects of the non-ideal transmitter component 14, like e.g. behavior over time, temperature and/or other less serious effects.

A challenging part is to describe and fit a neural network to a specific problem. Embodiments of the present invention propose to use a neural network to mitigate IQ imbalances at the output of the non-ideal analog transmitter device 14. The IQ imbalance behavior of a RF transceiver depends on used mixer components, their memory effects, like behavior over time and temperature, and other less serious effects. These are several reasons that make this problem interesting for neural networks, e.g., because IQ imbalance effects can be handled completely independent from a closed-form solution and without the need to describe them properly.

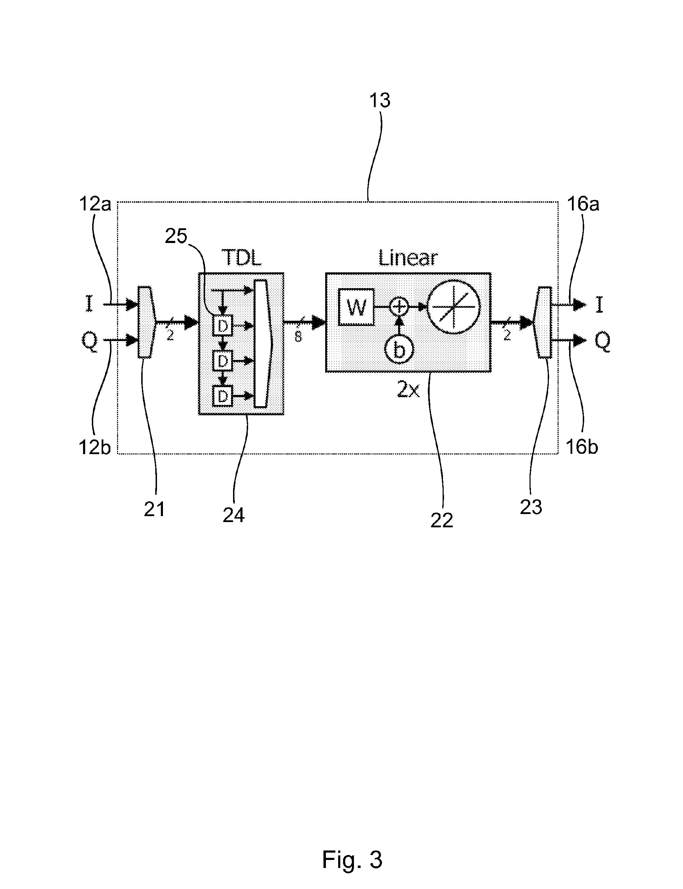

A specific embodiment of a pre-distortion neural network processor 13, which may be used for IQ imbalance mitigation, is depicted in Fig. 3.

For each quadrature component 12a, 12b the pre-distortion neural network processor 13 is organized in three layers, i.e. one (passive) input layer 21, one hidden layer 22 comprising at least one hidden neuron and one (passive) output layer 23. Optionally, the input layer 21 may be coupled to a time delay line structure 24 with three delay elements 25 for each quadrature component 12a, 12b. Without the optional time delay line structure 24 the pre-distortion neural network processor 13 for IQ imbalance compensation may comprise as few as six nodes or neurons, i.e. three nodes or neurons (one input node, one hidden neuron, one output node) for each quadrature component 12a, 12b. The hidden neurons of the pre-distortion neural network processor 13 may comprise an at least piecewise linear activation function $f(.)$, which is sufficient for IQ imbalance mitigation. The pre-distortion neural network processor 13 is fed with undistorted IQ parameters directly and generates pre-distorted IQ samples at its output which are then fed to the downstream located analog mixer device. As this distorts the pre-distorted IQ samples inversely, the output of the analog mixer device has approximately IQ balanced components. To handle memory effects and to improve the performance, three time delay lines or elements 25 may be used in the network for each quadrature component 12a, 12b.

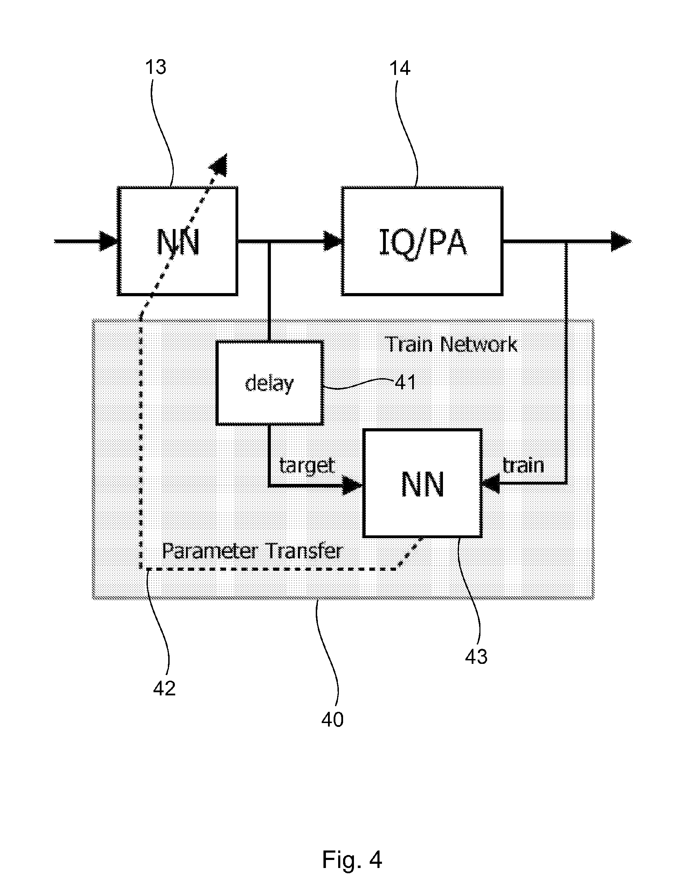

Fig. 4 illustrates how embodiments of the pre-distortion neural network processor 13 may be trained at a transmitter.

For training of the pre-distortion neural network processor 13 in the forward path the apparatus 10 may further comprise a training processor 40 for training weight ($w_{kj}$) and/or bias parameters ($b_k$) of neurons of the pre-distortion neural network processor 13. The training processor 40 may comprise a post distortion neural network 43 having the same network structure as the pre-distortion neural network 13 with respect to layers, nodes and neurons. The input layer of the post distortion neural network 43 may be coupled to the output of the non-ideal analog transmitter device 14. Sampled output values of the non-ideal analog transmitter device 14 may be fed back as input samples for the post distortion neural network 43. Undistorted and, hence, ideal digital baseband IQ samples 12a, 12b may be provided to the post distortion neural network 43 as target output values. In order to account for eventual signal delays introduced by the transmitter device 14, the undistorted digital baseband IQ samples 12a, 12b may be passed through a corresponding delay element 41 before being fed into the post distortion neural network 43. Hence, the undistorted digital baseband IQ samples 12a, 12b upstream to the analog transmitter device 14 may be provided to the post distortion neural network 43 as training data. The training may take several epochs and may be terminated by MSE (Minimum Squared Error). As the response of the post distortion neural network 43 converges, its response will essentially be the inverse of the transfer or distortion function of the analog transmitter device 14, which may comprise one or several IQ up-converter mixers, for example.

The training processor 40 may be adapted to train the weight ($w_{kj}$) and/or bias parameters ($b_k$) of the post distortion neural network 43 using the Levenberg-Marquardt training algorithm, such that a transfer function of the post distortion neural network approximates an inverse of the transmitter transfer function when the training has ended. After convergence of the post distortion neural network 43, the trained weight ($w_{kj}$) and/or bias parameters ($b_k$) of the post distortion neural network 43 may be transferred to the pre-distortion neural network processor 13, as is indicated by the dashed line 42. The training procedure may also be repeated at subsequent time instants in order to adapt the pre-distortion neural network processor 13 to time varying transmit transfer functions of the non-ideal analog transmitter device 14. In this case the time varying transmit transfer function may virtually be tracked. The pre-distortion neural network 13 in the forward path may be used for online signal processing while the second neural network 43 is needed for live adaptation of the pre-distortion neural network 13. For initial offline training and online use of a fixed trained pre-distortion network, the second network 43 is not necessary.

According to a further embodiment, the pre-distortion neural network processor 13 may be extended to additionally or alternatively overtake the task of power amplifier linearization, i.e., the pre-distortion neural network processor 13 may be adapted to additionally or alternatively compensate a nonlinear transmitter transfer function of at least one analog amplifier device in the transmitter device 14. Linearization of power amplifiers is more complex than IQ imbalance compensation due to the nonlinear behavior of the power amplifier.

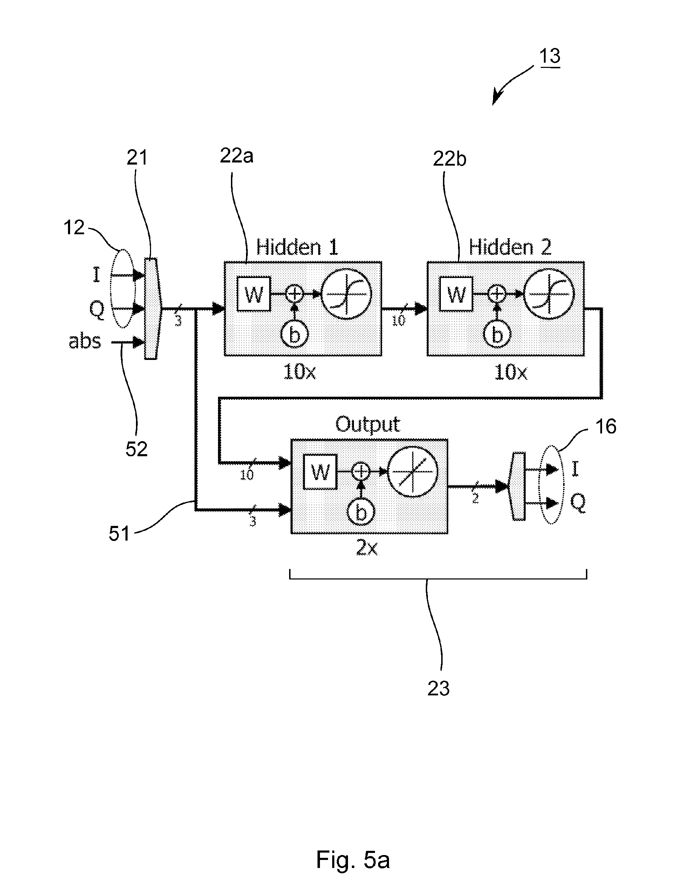

Embodiments which can handle power amplifier linearization in addition to IQ imbalance compensation are schematically depicted in Figs 5a to 5c.

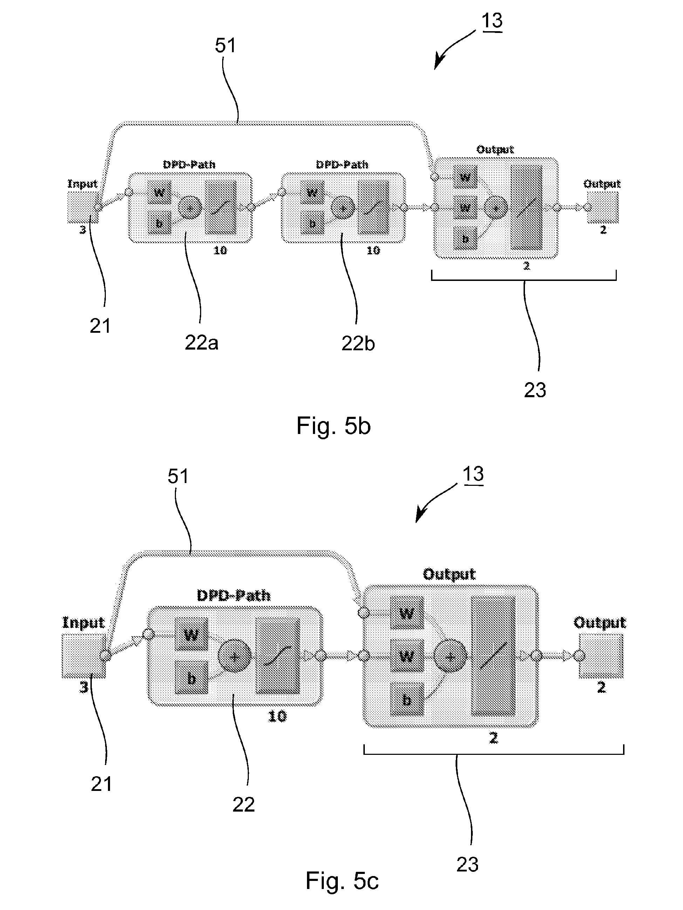

The embodiments of the pre-distortion neural network processor 13 illustrated in Figs. 5a to 5c each comprise an input layer 21 for the in-phase and the quadrature components 12a, 12b of the digital baseband transmit signal 12 and possibly or optionally delayed versions thereof. While the embodiment of the pre-distortion neural network processor 13 illustrated in Fig. 5c comprises only one hidden layer 22 for each of the baseband signal quadrature components 12a, 12b, which is connected between the input layer 21 and an output layer 23, the embodiments of the pre-distortion neural network processor 13 illustrated in Figs. 5a and 5b comprise two serially connected hidden layers 22a, 22b for each of the baseband signal quadrature components 12a, 12b connected between the input layer 21 and the output layer 23. The second hidden layer 22b is serially connected to the output layer 23 for outputting the in-phase and the quadrature component 16a, 16b of the pre-distorted digital baseband signal 16.

The embodiments of the pre-distortion neural network processor 13 illustrated in Figs. 5a to 5c are modified perceptrons with one or two hidden layers 22, 22a, 22b and one output layer 23 for each quadrature component. Neurons of the hidden layers 22, 22a and/or 22b each may have nonlinear transfer or activation functions with a hyperbolic tangent characteristic, in particular sigmoid transfer or activation functions. Due to this nonlinear activation functions embodiments of the pre-distortion neural network processor 13 gain the ability to compensate arbitrary nonlinear power amplifiers. Instead, the neurons of the output layer 23 may have at least piecewise linear transfer or activation functions for IQ imbalance compensation.

Further, embodiments of the pre-distortion neural network processor 13 comprise a network topology such that output signals of the input layer 21 are directly forwarded to the hidden layer 22 or 22a, as well as to the output layer 23 without travelling through the hidden layers 22, 22a or 22b. Hence, an additional direct path 51 from the input layer 21 to the output layer 23 is introduced in the network topology. With the direct path 51 it is possible to transfer input data presented to the input layer 21 directly to neurons of the output layer 23, thereby bypassing the intermediate hidden layers 22, 22a or 22b. Therefore embodiments of the pre-distortion neural network processor 13 gain the ability to split the linearization problem into a dominant linear part (for IQ imbalance compensation) mainly handled by the output layer 23 and a nonlinear part (for PA linearization) mainly handled by the hidden layers 22, 22a and/or 22b, which relaxes the requirements for the hidden layer size.

Additionally, not only the baseband IQ samples 12a, 12b, but also an absolute value 52 of the input digital baseband transmit signal 12 may be provided to embodiments of the pre-distortion neural network processor 13 at its input layer 21. Embodiments of the apparatus 10 may hence further comprise an input for the absolute value 52 of the input digital baseband transmit signal 12 (where $\mathrm{abs}(x) = \sqrt{x_I^2 + x_Q^2}$ ). The pre-distortion neural network processor 13, and hence its neurons, may be adapted to process the absolute value 52 in addition to the in-phase and the quadrature component 12a, 12b of the digital baseband transmit signal 12. With this pre-calculated additional information 52 the non-linear effects which are in most cases dependent on the power of the baseband transmit signal 12 can be described by the pre-distortion neural network processor 13 with less effort.

The additional direct path 51 for transporting the in-phase, the quadrature component 12a, 12b, and the absolute value 52 of the digital baseband transmit signal 12 directly from the input layer 21 to the output layer 23, and the additional input 52 itself, may result in a satisfying linearization performance with as few as ten neurons in each hidden layer 22, 22a and/or 22b. This means, for each of the in-phase and quadrature components, the corresponding quadrature components of the hidden layers 22, 22a, 22b may each comprise as little as five neurons, respectively. The output layer 23 of embodiments may comprise as little as two neurons, i.e. one neuron for each quadrature component of the output layer 23.

As has been described above, embodiments of the proposed pre-distortion neural network processor 13 may be extended by introducing a time delay line 24 at the pre-distortion neural network processor's input layer 21. Hence, the input layer 21 may comprise a plurality of delay elements connected in series for delaying the in-phase and/or the quadrature component 12a, 12b and/or the absolute value 52 of the input digital baseband transmit signal 12, respectively. With this modification memory effects in the power amplifier may also be compensated.

Embodiments of the pre-distortion neural network processor 13 of Figs. 5a-c may be trained by means of a training processor, as has already been explained with reference to Fig. 4. Embodiments of the training processor 40 may train weight and/or bias parameters of neurons of the pre-distortion neural network processor 13. The training processor 40 may comprise a post distortion neural network 43 having the same network structure as embodiments of the pre-distortion neural network 13. The training processor 40 may be adapted to train the weight and/or bias parameters of the post distortion neural network 43 using the Levenberg-Marquardt training algorithm such that a transfer function of the post distortion neural network 43 approximates an inverse of the transmitter transfer function, including a power amplifier's AM-AM and/or AM-PM distortion functions, as well as an IQ up-conversion mixer's transfer function. The trained weight and/or bias parameters of the post distortion neural network 43 may then be transferred to the pre-distortion neural network processor 13. This may be done only once (e.g. at the beginning of operation) or frequently in order to track time varying transfer function of the non-ideal transmitter devices 14.

As has been explained above, some embodiments of the apparatus 10 may also be applied to fragmented spectrum applications, e.g., when using a single transceiver device for transmitting in spectrally separated frequency bands with center frequencies $f_1$, $f_2$ of possibly different mobile communication systems, like e.g. GSM, WCDMA and/or LTE. That is to say, embodiments of the apparatus 10 may also comprise digital and non-ideal analog circuitry for supporting two or more frequency bands in parallel, e.g., using two mixers per frequency band and a power amplifier (dedicated or common). By parallel operation of fragmented frequency bands $f_1$, $f_2$, the number of parameters to be considered for non-linearity compensation of a transmitter rises, thus leading to increased challenges for optimization considering all the problems. By use of a self learning/optimizing neural network according to embodiments, the network parameters, i.e. weights $w_{kj}$, bias values $b_k$, etc., (addressing I/Q-imbalance and PA non-linearity in parallel for different frequency bands) may commonly be considered and optimized by embodiments of the present invention in a more advanced manner compared to use dedicated, non-self learning algorithms.

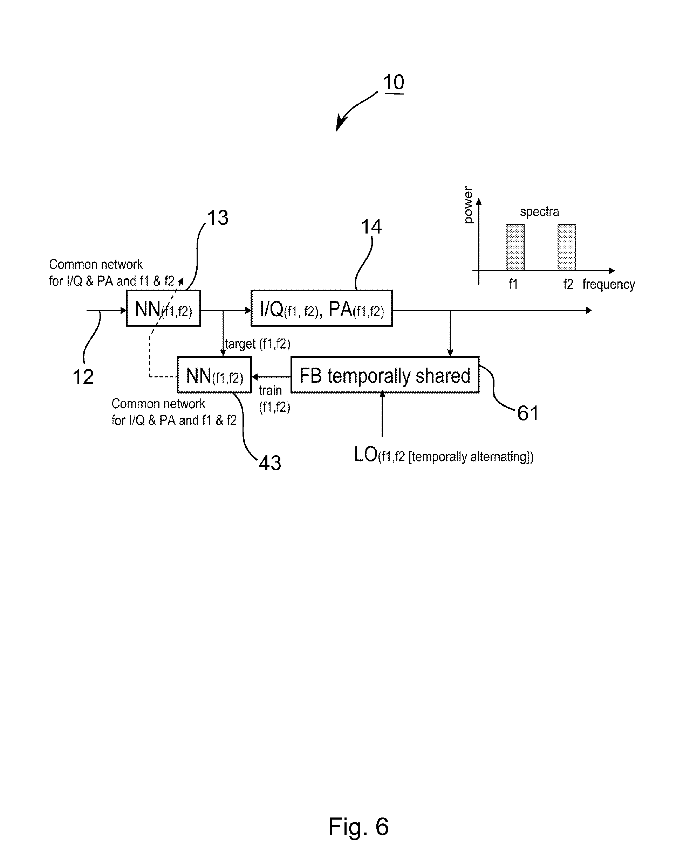

As illustrated in Fig. 6, information on the transmitter device's 14 output signal quality may e.g. be provided to the neural networks 13, 43 by use of a feedback path 61 in a time multiplexed manner, e.g. by temporally changing the LO-frequency of an IQ up-conversion mixer from $f_1$ to $f_2$ in the feedback path 61. Hence, in a further embodiment, the apparatus may comprise a feedback path 61, preferably for mitigating TX noise caused by the transmitter device 14, the feedback path being adapted for temporally alternately generating feedback on the different frequency bands of the fragmented spectrum RF signal. The feedback path typically provides an output signal of the transmitter device 14 to the post distortion neural network processing unit 43. The post distortion neural network processing unit 43 uses the feedback signal for enabling adaptive pre-distortion of the baseband signal, the pre-distortion being reciprocal to the distortion caused by the transmitter device's 14 non-ideal components, thus allowing for linearization of the amplification, for example.

In one embodiment, the feedback path 61 may comprise a plurality of frequency paths for the different frequency bands of the fragmented spectrum RF signal, the feedback path 61 further comprising at least one switch for switching between the frequency paths. For instance, one switch may be provided at the start and a further switch may be provided at the end of the parallel frequency paths for selectively connecting one frequency path to both, the transmitter device's 14 output and the post distortion neural network processing unit 43. Thus, the spectra of the two frequency bands (including the related inter-modulation distortions (IMDs) which are necessary for linearization) may be provided temporally alternately to the post distortion neural network processing unit 43. As efficient pre-distortion does not necessarily require an immediate adjustment of the pre-distortion of each frequency band, it may be sufficient for the pre-distortion to alternately consider two or more frequency bands for overall power amplifier linearization.

Each frequency path of the feedback path 61 may additionally comprise an intermediate frequency amplifier for amplification of a feedback signal which is related to one frequency band. Intermediate frequency (If) amplification may be performed for allowing an easier processing of the feedback signal in the digital signal processing unit.

For achieving successful linearization and thus high efficiency, the feedback path 61 bandwidth should be up to approx. four times the signal bandwidth. Since the bandwidth of currently used feedback paths is typically about 100 — 120 MHz, the supported signal bandwidth is limited to around 30 MHz and linearization of signals with fragmented frequency bands which are distributed e.g. over a frequency range of some 100 MHz cannot be supported. However, when performing switched feedback of only one frequency band in the way described above, the currently used bandwidth of the feedback path of about 100 to 120 MHz is sufficient for performing linearization over the entire (wideband) bandwidth range of the fragmented spectrum RF signal.

Each of the frequency paths of the feedback path 61 may comprise a filter for generating a feedback signal related to one of the frequency bands of the fragmented spectrum RF signal. The filter may be typically implemented as a band-pass filter which is adapted for passing only the selected frequency band of the feedback signal to the filter output.

A mixer may be provided in the feedback path 61 for down-conversion of the fragmented spectrum RF signal, preferably to an intermediate frequency. The mixer may be provided in the feedback path 61 before a switch which divides the feedback path 61 into the different frequency paths. Thus, the feedback signal which is provided to the frequency paths is an intermediate frequency (IF) signal, allowing simplified signal processing in the individual frequency paths. Alternatively, a splitter may be used for providing the amplified fragmented spectrum RF signal as an input to two parallel (single-band) mixers, each mixer being arranged in a different frequency path and having a local oscillator frequency which is chosen in dependence of the carrier frequency $f_1$, $f_2$ of the addressed frequency band. A switch may be used for switching between the parallel frequency paths for providing the currently addressed down-converted signal from one of the mixers to a filter and subsequently to an IF amplifier.

In a further embodiment a wideband capable mixer may be adapted for switching its local oscillator frequency in dependence of the frequency band of the amplified fragmented spectrum RF signal for which the feedback is to be generated. By temporally alternating the local oscillator frequency of the (wideband) mixer based on the fragmented frequency band to be currently supported ($f_1$ or $f_2$), the same feedback hardware can be used in a time-shared manner, such that the use of parallel frequency paths can be dispensed with.

It will be understood that the equipment arranged in the feedback path is not limited to the devices described above and may be subject to modification. For example, instead of using conversion to an intermediate frequency, direct down-conversion to the baseband frequency range may be performed. Also, instead of using two IF amplifiers, it may be possible to use a single (broadband) IF amplifier for both frequency ranges. Also, only a single filter, possibly having an adjustable filter characteristic, may be deployed in the feedback path.

Hence, embodiments of the apparatus 10 may be adapted for parallel operation of spectrally fragmented frequency bands with center frequencies $f_1$ and $f_2$, wherein embodiments of the pre-distortion neural network processor 13 may be adapted to pre-distort the input digital baseband transmit signal to obtain a plurality of pre-distorted digital baseband signals, each for a different one of a plurality of analog transmitter devices corresponding to a different one of the plurality fragmented frequency bands $f_1$ and $f_2$.

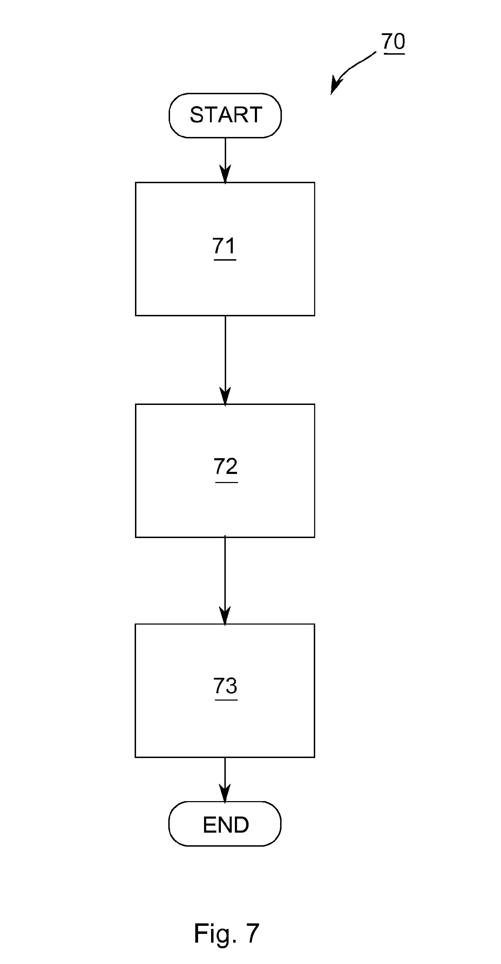

Fig. 7 schematically depicts a flow chart of a method 70 for mitigating transmitter impairments of a transmit signal, according to an embodiment.

The method 70 comprises a step 71 of receiving an in-phase and a quadrature component 12a, 12b of a digital baseband transmit signal 12. In step 72 a pre-distortion neural network processor 13 is used for pre-distorting the in-phase and quadrature component of the digital baseband transmit signal 12 to obtain a pre-distorted digital baseband signal 16, wherein the pre-distortion neural network processor 13 is adapted to a transmitter transfer function of at least one analog transmitter device 14 arranged downstream to the pre-distortion neural network processor 13, such that a transfer function of the pre-distortion neural network processor 13 approximates an inverse of said transmitter transfer function. Further, the method 70 comprises a step 73 of outputting an in-phase and a quadrature component 16a, 16b of the pre-distorted digital baseband signal 16, which may be coupled to an input of the at least one analog transmitter device 14 arranged downstream to the pre-distortion neural network processor 13.

The apparatus 10 for mitigating transmitter impairments may comprise a signal processor executing a computer program having a program code for performing or supporting at least one of the above described method-steps 71 to 73, when the computer program is executed on said processor. Hence, embodiments may provide a computer program having a program code for performing one of the above described methods when the computer program is executed on a computer or processor. A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

To summarize, embodiments may enable a self-intelligent and self-adapting solution in order to increase flexibility of the whole RF transmitter. The digital part of the transmitter gets more flexible regarding the analog frontend. Any mixer or PA could be used without specially analyzing the components to adjust algorithms. In an embodiment a neural networking unit may be directly placed in the IQ path of the digital baseband signal. The neural network may operate directly in the digital baseband signal path and actively process the signal. That means that the neural network may be part of the transmitter loop including transmit and feedback path. The neural network may learn from a feedback signal and adapt itself to achieve required results. Compensation and linearization algorithm are no more necessary. There are different neural networks architectures suitable to mitigate the impairments of the analog transmit path. One embodiment that has shown good results is a multilayer feed-forward neural network using perceptrons with sigmoid and linear transfer-functions. A size of embodiments of the neural network that is able to solve the PA linearization and IQ-imbalance compensation at the same time may be chosen to around 25 neurons overall in the input-, hidden- and output-layer. The network may be trained initially to fit on the "problem" to solve the impairments online in the signal path by signal processing in a non-adapting state after it has been trained or it may be adapted online to fit the neural network to the problem or to compensate variations over time, like memory effects of the analog components. In comparison to the algorithmic solution the neural networks may show better results, especially when the problem gets more complex or the PA does not show a simple non-linear behavior. Embodiments may also be applied to fragmented transmitter applications. An exemplarily transmitter may support two frequency bands in parallel, using two mixers per frequency band, each and a power amplifier (dedicated or common). By parallel operation of fragmented frequency bands, the number of parameters to be considered for non-linearity compensation of the transmitter rises, leading to increased challenges for optimization considering all the problems. By use of self learning/optimizing neural networks according to embodiments, the parameters (addressing I/Q-imbalance, PA non-linearity, in parallel for different frequency bands) are commonly considered and optimized by the neural network in a more advanced manner compared to use dedicated, non-self-learning algorithms. Information of the signal quality may e.g. be provided to the neural network by use of a feedback path in time multiplexed manner e.g. by temporally changing the LO-frequency of the mixer in the feedback path.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

**Claims**

1. An apparatus (10) for mitigating transmitter impairments of a transmit signal, the apparatus comprising:

   an input (11a; 11b) for an in-phase and a quadrature component (12a; 12b) of a digital baseband transmit signal (12);
   a pre-distortion neural network processor (13) for pre-distorting the input digital baseband transmit signal (12; 12a; 12b) to obtain a pre-distorted digital baseband signal (16; 16a; 16b), wherein the pre-distortion neural network processor (13) is adaptable to a transmitter transfer function of at least one analog transmitter device (14) arranged downstream to the pre-distortion neural network processor (13) such that a transfer function of the pre-distortion neural network processor (13) approximates an inverse of said transmitter transfer function; and
   an output (15a; 15b) for an in-phase and a quadrature component (16a; 16b) of the pre-distorted digital baseband signal (16), which may be coupled to an input of the at least one analog transmitter device (14) arranged downstream to the pre-distortion neural network processor (13).

2. The apparatus (10) according to claim 1, wherein the pre-distortion neural network processor (13) is adapted to compensate for a transmitter transfer function of at least one analog transmitter device (14) causing an IQ imbalance between an in-phase and the quadrature component of an transmitter device's (14) output signal.

3. The apparatus (10) according to claim 2, wherein the pre-distortion neural network processor (13) comprises a feed-forward neural network having an input layer (21) for the in-phase and the quadrature components (12a; 12b) of the digital baseband transmit signal (12) and/or delayed versions thereof, a hidden layer (22; 22a; 22b), and an output layer (23) for the in-phase and the quadrature component (16a; 16b) of the pre-distorted digital baseband signal (16).

4. The apparatus (10) according to claim 3, wherein the input layer (21) is coupled to a plurality of delay elements (25) connected in series for delaying the in-phase and the quadrature component (12a; 12b) of the digital baseband transmit signal (12), respectively, and/or wherein neurons of the feed-forward neural network comprise an at least piecewise linear transfer or activation function.

5. The apparatus (10) according to claim 1, wherein the pre-distortion neural network processor (13) is adapted to compensate for a nonlinear transmitter transfer function of at least one analog amplifier device (14).

6. The apparatus (10) according to claim 5, wherein the pre-distortion neural network processor (13) comprises an input layer (22) for the in-phase and the quadrature components (12a; 12b) of the digital baseband transmit signal and/or delayed versions thereof, two hidden layers (22a; 22b), and an output layer (23) for the in-phase and the quadrature component (16a; 16b) of the pre-distorted digital baseband signal.

7. The apparatus (10) according to claim 6, wherein neurons of the two hidden layers (22a; 22b) have nonlinear activation functions, in particular sigmoid activation functions, and wherein neurons of the output layer (23) have at least piecewise linear activation functions.

8. The apparatus (10) according to claim 6, wherein the pre-distortion neural network processor (13) comprises a network topology such that output signals of the input layer (21) are forwarded to one of the hidden layers (22a; 22b) and directly forwarded (51) to the output layer (23) without travelling through any of the hidden layers (22a; 22b).

9. The apparatus (10) according to claim 5, wherein the apparatus further comprises an input for an absolute value (52) of the digital baseband transmit signal (12) comprising the in-phase and the quadrature component (12a; 12b), and wherein the pre-distortion neural network processor (13) is adapted to process the absolute value (52) in addition to the in-phase and the quadrature component (12a; 12b) of the digital baseband transmit signal.

10. The apparatus (10) according to claim 6, wherein the two hidden layers (22a; 22b) for the in-phase and quadrature components (12a; 12b) each comprise at least ten neurons, and wherein the output layer (23) comprises at least two neurons.

11. The apparatus (10) according to claim 6, wherein the input layer (21) comprises a plurality of delay elements (25) connected in series for delaying the in-phase and/or the quadrature component (12a; 12b) and/or a corresponding absolute value (52) of the input digital baseband transmit signal (12), respectively.

12. The apparatus (10) according to claim 1, wherein the apparatus further comprises a training processor (40) for training weight and/or bias parameters of neurons of the pre-distortion neural network processor (13), wherein the training processor (40) comprises a post distortion neural network (43) having the same network structure as the pre-distortion neural network (13), and wherein the training processor (40) is adapted to train the weight and/or bias parameters of the post distortion neural network (43) using the Levenberg-Marquardt training algorithm such that a transfer function of the post distortion neural network (43) approximates an inverse of the transmitter transfer function, and to transfer the trained weight and/or bias parameters of the post distortion neural network (43) to the pre-distortion neural network processor (13).

13. The apparatus (10) according to claim 1, wherein the apparatus is adapted for parallel operation of spectrally fragmented frequency bands, wherein the neural network processor (13) is adapted to pre-distort the input digital baseband transmit signal to obtain a plurality of pre-distorted digital baseband signals, wherein each of the pre-distorted digital baseband signals corresponds to a different one of the fragmented frequency bands.

14. A method (70) for mitigating transmitter impairments of a transmit signal, the method comprising:

receiving (71) an in-phase and a quadrature component (12a; 12b) of a digital baseband transmit signal (12);
using (72) a neural network processor (13) for pre-distorting the in-phase and quadrature component (12a; 12b) of the digital baseband transmit signal (12) to obtain a pre-distorted digital baseband signal (16), wherein the neural network processor (13) is adapted to a transmitter transfer function of at least one analog transmitter device (14) arranged downstream to the neural network such that a transfer function of the neural network processor (13) approximates an inverse of said transmitter transfer function; and
outputting (73) an in-phase and a quadrature component (16a; 16b) of the pre-distorted digital baseband signal (16), which may be coupled to an input of the at least one analog transmitter device (14) arranged downstream to the neural network processor (13).

15. A computer program having a program code for performing the steps of the method of claim 14, when the computer program is executed on a computer or processor.

**Amended claims in accordance with Rule 137(2) EPC.**

1. An apparatus (10) for mitigating transmitter impairments of a transmit signal, the apparatus comprising:

an input (11a; 11b) for an in-phase and a quadrature component (12a; 12b) of a digital baseband transmit signal (12);
a pre-distortion neural network processor (13) for pre-distorting the digital baseband transmit signal (12; 12a; 12b) to obtain a pre-distorted digital baseband signal (16; 16a; 16b), wherein the pre-distortion neural network processor (13) is adaptable to a transmitter transfer function of at least one analog transmitter device (14) for the transmit signal arranged downstream to the pre-distortion neural network processor (13) such that a transfer function of the pre-distortion neural network processor (13) approximates an inverse of said transmitter transfer function, wherein the pre-distortion neural network processor (13) comprises an input layer (22) for the in-phase and the quadrature components (12a; 12b) of the digital baseband transmit signal and/or delayed versions thereof, at least one hidden layer (22a; 22b), and an output layer (23) for the in-phase and the quadrature component (16a; 16b) of the pre-distorted digital baseband signal and wherein the pre-distortion neural network processor (13) comprises a network topology such that output signals of the input layer (21) are forwarded to at least one hidden layer (22a; 22b) and directly forwarded (51) to the output layer (23) without travelling through any of the at least one hidden layer (22a; 22b); and

an output (15a; 15b) for an in-phase and a quadrature component (16a; 16b) of the pre-distorted digital baseband signal (16), which may be coupled to an input of the at least one analog transmitter device (14) arranged downstream to the pre-distortion neural network processor (13).

**2.** The apparatus (10) according to claim 1, wherein the pre-distortion neural network processor (13) is adapted to compensate for the transmitter transfer function of the at least one analog transmitter device (14) causing an IQ imbalance between an in-phase and a quadrature component of the at least one analog transmitter device's (14) output signal.

**3.** The apparatus (10) according to claim 2, wherein the pre-distortion neural network processor (13) comprises a feed-forward neural network having an input layer (21) for the in-phase and the quadrature components (12a; 12b) of the digital baseband transmit signal (12) and/or delayed versions thereof, a hidden layer (22, 22a; 22b), and an output layer (23) for the in-phase and the quadrature component (16a; 16b) of the pre-distorted digital baseband signal (16).

**4.** The apparatus (10) according to claim 3, wherein the input layer (21) is coupled to a plurality of delay elements (25) connected in series for delaying the in-phase and the quadrature component (12a; 12b) of the digital baseband transmit signal (12), respectively, and/or wherein neurons of the feed-forward neural network comprise an at least piecewise linear transfer or activation function.

**5.** The apparatus (10) according to claim 1, wherein the pre-distortion neural network processor (13) is adapted to compensate for a nonlinear transmitter transfer function of at least one analog amplifier device (14) as the at least one analog transmitter device.

**6.** The apparatus (10) according to claim 5, wherein the pre-distortion neural network processor (13) comprises an input layer (22) for the in-phase and the quadrature components (12a; 12b) of the digital baseband transmit signal and/or delayed versions thereof, two hidden layers (22a; 22b), and an output layer (23) for the in-phase and the quadrature component (16a; 16b) of the pre-distorted digital baseband signal.

**7.** The apparatus (10) according to claim 6, wherein neurons of the two hidden layers (22a; 22b) have nonlinear activation functions and wherein neurons of the output layer (23) have at least piecewise linear activation functions.

**8.** The apparatus (10) according to claim 5, wherein the apparatus further comprises an input for an absolute value (52) of the digital baseband transmit signal (12) comprising the in-phase and the quadrature component (12a; 12b), and wherein the pre-distortion neural network processor (13) is adapted to process the absolute value (52) in addition to the in-phase and the quadrature component (12a; 12b) of the digital baseband transmit signal.

**9.** The apparatus (10) according to claim 6, wherein the two hidden layers (22a; 22b) for the in-phase and quadrature components (12a; 12b) each comprise at least ten neurons, and wherein the output layer (23) comprises at least two neurons.

**10.** The apparatus (10) according to claim 6, wherein the input layer (21) comprises a plurality of delay elements (25) connected in series for delaying the in-phase and/or the quadrature component (12a; 12b) and/or a corresponding absolute value (52) of the input digital baseband transmit signal (12), respectively.

**11.** The apparatus (10) according to claim 1, wherein the apparatus further comprises a training processor (40) for training weight and/or bias parameters of neurons of the pre-distortion neural network processor (13), wherein the training processor (40) comprises a post distortion neural network (43) having the same network structure as the pre-distortion neural network (13), and wherein the training processor (40) is adapted to train the weight and/or bias parameters of the post distortion neural network (43) using the Levenberg-Marquardt training algorithm such that a transfer function of the post distortion neural network (43) approximates the inverse of the transmitter transfer function, and to transfer the trained weight and/or bias parameters of the post distortion neural network (43) to the pre-distortion neural network processor (13).

**12.** The apparatus (10) according to claim 1, wherein the apparatus is adapted for parallel operation of spectrally fragmented frequency bands, wherein the pre-distortion neural network processor (13) is adapted to pre-distort the input digital baseband transmit signal to obtain a plurality of pre-distorted digital baseband signals, wherein each of the pre-distorted digital baseband signals corresponds to a different one of the fragmented frequency bands.

**13.** The apparatus (10) according to claim 12, wherein the apparatus comprises a feedback path (61), the feedback path (61) providing an output signal of the at least one analog transmitter device (14) to a post distortion neural network (43), and wherein the feedback path (61) is adapted to temporally alternately generate feedback on a different one of the fragmented frequency bands.

**14.** A method (70) for mitigating transmitter impairments of a transmit signal, the method comprising:

receiving (71) an in-phase and a quadrature component (12a; 12b) of a digital baseband transmit signal (12); using (72) a neural network processor (13) for pre-distorting the in-phase and quadrature component (12a; 12b) of the digital baseband transmit signal (12) to obtain a pre-distorted digital baseband signal (16), wherein the neural network processor (13) is adapted to a transmitter transfer function of at least one analog transmitter device (14) for the transmit signal arranged downstream to the neural network processor such that a transfer function of the neural network processor (13) approximates an inverse of said transmitter transfer function, wherein the neural network processor (13) comprises an input layer (22) for the in-phase and the quadrature components (12a; 12b) of the digital baseband transmit signal and/or delayed versions thereof, at least one hidden layer (22a; 22b), and an output layer (23) for the in-phase and the quadrature component (16a; 16b) of the pre-distorted digital baseband signal and wherein the neural network processor (13) comprises a network topology such that output signals of the input layer (21) are forwarded to at least one hidden layer (22a; 22b) and directly forwarded (51) to the output layer (23) without travelling through any of the at least one hidden layer (22a; 22b); and outputting (73) an in-phase and a quadrature component (16a; 16b) of the pre-distorted digital baseband signal (16), which may be coupled to an input of the at least one analog transmitter device (14) arranged downstream to the neural network processor (13).

**15.** A computer program having a program code for performing the steps of the method of claim 14, when the computer program is executed on a computer or processor.

Fig. 1

Fig. 2

Fig. 3

Fig. 4

Fig. 5a

Fig. 5b

Fig. 5c

**10**

Common network
for I/Q & PA and f1 & f2

13

NN(f1,f2)

14

I/Q(f1, f2), PA(f1,f2)

power    spectra

f1        f2   frequency

12

target (f1,f2)

NN(f1,f2)

Common network
for I/Q & PA and f1 & f2

train
(f1,f2)

FB temporally shared

61

43

LO(f1,f2 [temporally alternating])

Fig. 6

Fig. 7

Europäisches
Patentamt
European
Patent Office
Office européen
des brevets

# EUROPEAN SEARCH REPORT

**Application Number**

EP 11 30 5781

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 101 320 960 A (UNIV SOUTHEAST [CN] UNIV SOUTHEAST) 10 December 2008 (2008-12-10)<br>* page 4, lines 9-10, paragraph 1. full *<br>* page 5, lines 6-8 *<br>* page 5, line 5 from bottom *<br>* page 6, lines 11-27 *<br>* figures 1,2,3 *<br>----- | 1-15 | INV.<br>H03F1/32<br>H04L25/03<br>H04L27/36 |
| X | WATKINS B E ET AL: "Neural network based adaptive predistortion for the linearization of nonlinear RF amplifiers", MILITARY COMMUNICATIONS CONFERENCE, 1995. MILCOM '95, CONFERENCE RECOR D, IEEE SAN DIEGO, CA, USA 5-8 NOV. 1995, NEW YORK, NY, USA,IEEE, US,<br>vol. 1, 5 November 1995 (1995-11-05), pages 145-149, XP010153948,<br>DOI: 10.1109/MILCOM.1995.483288<br>ISBN: 978-0-7803-2489-3<br>* page 145, right-hand column, paragraph 2. full *<br>* page 147 - page 148, paragraph 1. full *<br>----- | 1-15 | |
| X | BENVENUTO N ET AL: "A neural network approach to data predistortion with memory in digital radio systems", PROCEEDINGS OF THE INTERNATIONAL CONFERENCE ON COMMUNICATIONS (ICC). GENEVA, MAY 23 - 26, 1993; [PROCEEDINGS OF THE INTERNATIONAL CONFERENCE ON COMMUNICATIONS (ICC)], NEW YORK, IEEE, US,<br>vol. 1, 23 May 1993 (1993-05-23), pages 232-236, XP010136900,<br>DOI: 10.1109/ICC.1993.397263<br>ISBN: 978-0-7803-0950-0<br>* figures 2, 4 *<br>----- | 1,5-8, 10-15 | **TECHNICAL FIELDS SEARCHED (IPC)**<br>H03F<br>H04L |

The present search report has been drawn up for all claims

| Place of search | Date of completion of the search | Examiner |
|---|---|---|
| Berlin | 23 November 2011 | Feng, Mei |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 11 30 5781

This annex lists the patent family members relating to the patent documents cited in  the above-mentioned European search report.
The members are as contained in the European Patent Office EDP file on
The European Patent Office is in no way liable for these particulars which are merely given for the purpose of information.

23-11-2011

| Patent document cited in search report | Publication date | Patent family member(s) | Publication date |
|---|---|---|---|
| CN 101320960 A | 10-12-2008 | NONE | |

EPO FORM P0459

For more details about this annex : see Official Journal of the European Patent Office, No. 12/82